# EUROPÄISCHE PATENTSCHRIFT

(11) **EP 3 170 253 B1**
(45) Veröffentlichungstag und Bekanntmachung des Hinweises auf die Patenterteilung: **17.07.2019**
(21) Anmeldenummer: 15726143.9
(22) Anmeldetag: 01.06.2015
(51) Int. Cl.: H02N 2/06, H03K 4/92

(54) **PHASENABSCHNITTSTEUERUNG VON PIEZOAKTOREN**
PHASE-CHOPPING CONTROL OF PIEZOELECTRIC ACTUATORS
COMMANDE À DÉCOUPAGE DE PHASE POUR ACTIONNEURS PIÉZO-ÉLECTRIQUES

(30) Priorität: 16.07.2014 DE 102014110003
(43) Veröffentlichungstag der Anmeldung: 24.05.2017
(73) Patentinhaber: Vermes Microdispensing GmbH, 83624 Otterfing (DE)
(72) Erfinder: STÄDTLER, Jürgen, 83620 Feldkirchen-Westerham (DE); FLIESS, Mario, 81549 München (DE); KARGER, Jiri, 80807 München (DE)
(74) Vertreter: Beckord & Niedlich Patentanwälte PartG mbB
(86) Internationale Anmeldenummer: PCT/EP2015/062129
(87) Internationale Veröffentlichungsnummer: WO 2016/008633

(56) Entgegenhaltungen:
- WO-A1-2013/187871
- WO-A2-2004/066481

## Beschreibung

Die Erfindung betrifft eine Piezo-Ansteuerungsschaltung und ein Verfahren zur Ansteuerung einer Piezoaktor-Anordnung.

In vielen Bereichen der Technik, insbesondere der Fertigungstechnik, werden Piezoaktoren zur Steuerung von mechanischen Bewegungen verwendet. Zur Steuerung einer mechanischen Bewegung wird an einen Piezoaktor eine bestimmte Spannung angelegt, welche aufgrund des inversen Piezoeffekts zu einer mechanischen Bewegung, genauer gesagt, einem Zusammenziehen oder Ausdehnen des Piezoaktors führt. Der Piezoaktor bewegt seinerseits durch diese mechanische Bewegung ein Betätigungselement, wie zum Beispiel einen Stößel oder einen Hebel. Ein Piezoaktor umfasst mindestens ein Piezoelement oder eine Gruppe von zueinander seriell geschalteten oder parallel geschalteten Piezoelementen. Seriell geschaltete Piezoelemente können beispielsweise als Piezostapel, auch Piezostacks genannt, eingesetzt werden, wobei ein Piezostack einen entsprechend größeren Hub als ein einzelnes Piezoelement aufweist.

Beispielsweise kommen bei dem Aufbringen und Dosieren von dünnflüssigen oder pastösen Medien, insbesondere bei dem Aufbringen von Klebstoffen, Dosierventile zum Einsatz, die einen Ventilstößel umfassen, der mit einem Aktor, beispielsweise einem Piezoaktor, angesteuert wird. Der Piezoaktor wird über ein an dem Piezoaktor anliegendes Steuersignal mit einer Steuerspannung angesteuert und führt eine mechanische Bewegung aus, mit der der Ventilstößel betätigt wird. Das Ausmaß der Öffnung des Dosierventils kann über den Wert der Steuerspannung des Piezoaktors gesteuert werden. Die Menge des abgegebenen Mediums hängt zudem von der Dauer der Öffnung des Ventils ab. Die Dauer der Öffnung des Ventils hängt von der Frequenz der Steuerspannung ab.

Herkömmlich wird das dem Steuersignal für die Ansteuerung der Piezoaktoren zugrundeliegende Signal durch spezielle Funktionsgeneratoren mit Oszillatoren erzeugt. Einfache Funktionsgeneratoren mit analoger Schaltungstechnik enthalten einen einstellbaren Dreieck-Oszillator, dessen Ausgangssignal über eine nichtlineare Schaltung in ungefähre Sinusform gebracht wird. Bei diesen Geräten weisen die Sinusausgänge im Allgemeinen einen relativ hohen Klirrfaktor auf. Das Rechtecksignal wird aus dem Dreieck mittels eines Komparators erzeugt, wobei durch Veränderung der Vergleichsspannung die Impulsbreite des Rechtecks eingestellt werden kann. Allerdings ist die Präzision dieser Art von Funktionsgeneratoren sehr eingeschränkt. Digitale Funktionsgeneratoren arbeiten mit direkter digitaler Synthese (DDS) und können verschiedene periodische Signalverläufe generieren. Die Genauigkeit ist wesentlich höher als bei Geräten mit analoger Schaltungstechnik und hängt primär von der internen Auflösung in der DDS ab. Als Taktquelle dient im Regelfall ein Quarzoszillator, welcher die DDS taktet. Zwar bietet diese Art von Spannungsquellen eine hohe Genauigkeit, allerdings sind sie, da meist für einen breiten Einsatzbereich konzipiert, entsprechend aufwendig konstruiert und daher sehr teuer.

In WO 2004/ 066 481 A2 werden eine Vorrichtung und ein Verfahren zum Übertragen und Bereitstellen der Energie kapazitiver Aktuatoren beschrieben. Bei dem Verfahren wird durch einen Frequenzgenerator ein Wechselstrom höherer Frequenz mit einer von der Phasenlage und der Amplitude einer Gegenspannung unabhängigen Amplitude erzeugt und mittels eines induktiven Übertragers auf ein bewegtes Teilsystem übertragen. Der von der Sekundärwicklung des Übertragers ausgehende höherfrequente Wechselstrom wird mittels einer elektronischen Stelleinrichtung getrennt nach positiven und negativen Halbschwingungen oder Abschnitten von diesen Halbschwingungen in derjenigen Richtung in den Aktuator eingeprägt, dass in jeder Halbschwingung eine Längenänderung des Aktuators in einer gewünschten Richtung auftritt.

Es ist eine Aufgabe der vorliegenden Erfindung, eine kostengünstige und ausreichend exakte Ansteuerungsschaltung für Piezoaktoren und ein entsprechendes Verfahren zur Ansteuerung von Piezoaktoren zu entwickeln.

Diese Aufgabe wird durch eine Piezo-Ansteuerungsschaltung gemäß Patentanspruch 1, ein Verfahren gemäß Patentanspruch 11, eine Piezoaktor-Einrichtung gemäß Patentanspruch 14 und ein Dosierventil gemäß Patentanspruch 15 gelöst.

Die erfindungsgemäße Piezo-Ansteuerungsschaltung weist einen Eingang auf, an welchem ein zeitlich veränderliches Spannungssignal bereitgestellt wird. Das am Eingang anliegende Spannungssignal kann beispielsweise von einem standardisierten Netzanschluss, wie zum Beispiel einem 50 Hz- oder 60Hz-Netzanschluss, stammen. Die Piezo-Ansteuerungsschaltung weist weiterhin eine Piezo-Schnittstelle zum Anschluss von Kontakten einer Piezoaktor-Anordnung mit mindestens einem spannungsgesteuerten Piezoaktor auf. Eine Piezoaktor-Anordnung umfasst mindestens einen Piezo-Aktor, es kann aber auch eine Mehrzahl von Piezoaktoren als Piezoaktor-Anordnung parallel geschaltet sein, oder die Piezoaktor-Anordnung kann auch in einzelne Gruppen von zueinander parallel geschalteten Piezoaktoren eingeteilt sein. Die Schnittstelle kann zum Beispiel Kontakte umfassen, mit denen der Piezoaktor bzw. die Piezoaktoren bzw. die Piezoaktor-Anordnung an die Piezo-Ansteuerungsschaltung elektrisch angeschlossen sind. Zudem umfasst die Piezo-Ansteuerungsschaltung eine Sync-Kontrollschaltung, welche dazu eingerichtet ist, die Phasenlage des Spannungssignals zu detektieren, und eine Umrichterschaltung zwischen dem Eingang und der Piezo-Schnittstelle. Die Umrichterschaltung kann beispielsweise eine Gleichrichterschaltung sein, mit der eine Wechselspannung derart zerlegt und zusammengefügt wird, dass sich eine Gleichspannung ergibt. Die Sync-Kontrollschaltung kann als eine Art Ablaufsteuerung angesehen werden. Die Sync-Kontrollschaltung ist dazu eingerichtet, in Abhängigkeit von der Phasenlage des Spannungssignals die Umrichterschaltung derart anzusteuern, dass an der Piezo-Schnittstelle eine Steuerspannung mit einer vorbestimmten Spannungszeitkurve anliegt. Anders ausgedrückt, erfasst die Sync-Kontrollschaltung das zeitliche Verhalten des Spannungssignals und zerteilt auf Basis dieser Information das Spannungssignal derart und fügt es entsprechend zusammen, dass ein Signal mit einer Spannungszeitkurve mit einer vorbestimmten Form und Frequenz entsteht. Damit lassen sich beispielsweise exakte Dosierungen von dünnflüssigen oder pastösen Medien mit Hilfe von Dosierventilen, die von Piezoaktoren gesteuert werden, realisieren. Bei hinreichender Exaktheit der Steuerung kann vorteilhaft auf eine aufwändigere Wechselspannungsquelle, wie zum Beispiel einen Funktionsgenerator, verzichtet werden.

Ein besonderer durch die Erfindung erreichter Vorteil kann darin gesehen werden, dass ein Standardspannungssignal, das von einer Wechselspannungsquelle, wie zum Beispiel einem standardisierten Netzanschluss, bereitgestellt wird, als Eingangsspannung verwendet werden kann und aus dem Standardspannungssignal Abschnitte der Spannungskurve herausgeschnitten und zusammenzufügt werden, so dass sich eine Spannungszeitkurve der gewünschten Form und Frequenz ergibt.

Bei dem erfindungsgemäßen Verfahren zur Ansteuerung einer Piezoaktor-Anordnung wird ein Spannungssignal empfangen und es werden Kurvenabschnitte des Spannungssignals durch Umpolen des Spannungssignals gemäß einem vorbestimmten Schaltschema zerlegt und zusammengefügt. Das umgepolte Spannungssignal wird als Steuerspannung an eine Piezo-Schnittstelle zum Anschluss von Kontakten einer Piezoaktor-Anordnung mit mindestens einem spannungsgesteuerten Piezoaktor angelegt.

Die erfindungsgemäße Piezoaktor-Einrichtung weist eine Piezo-Ansteuerungsschaltung, die die erfindungsgemäßen Merkmale umfasst, und eine Piezoaktor-Anordnung auf.

Das erfindungsgemäße Dosierventil weist eine Piezoaktor-Einrichtung auf, die die erfindungsgemäßen Merkmale umfasst.

Weitere besonders vorteilhafte Ausgestaltungen und Weiterbildungen der Erfindung ergeben sich aus den abhängigen Ansprüchen sowie der nachfolgenden Beschreibung.

In einer vorteilhaften Ausgestaltung der erfindungsgemäßen Piezo-Ansteuerungsschaltung umfasst die Umrichterschaltung eine Schaltmatrix mit einer Mehrzahl von in Zeilenrichtung verlaufenden Leitungen, einer Mehrzahl von in Spaltenrichtung verlaufenden Leitungen und einer Mehrzahl von Schaltern, die an den Kreuzungspunkten der Schaltmatrix angeordnet sind und jeweils eine in Zeilenrichtung verlaufende Leitung mit einer in Spaltenrichtung verlaufenden Leitung verbinden. Die Schalter sind zur Steuerung der Schalter mit einem Steuerungssignal an die Sync-Kontrollschaltung angeschlossen. Beispielsweise können die Schalter mit der Sync-Kontrollschaltung über separate, jeweils den einzelnen Schaltern zugeordnete, parallele Leitungen verbunden sein. Alternativ können die Schalter auch über eine Schaltmatrix angesteuert werden.

Gemäß einer besonders vorteilhaften Ausgestaltung weist die Piezo-Ansteuerungsschaltung einen Entladeschalter auf, der parallel zu der Piezo-Schnittstelle geschaltet ist. Der Entladeschalter dient dazu, die Spannung zwischen den Piezokontakten auch asynchron, d. h. unabhängig von der durch die Eingangsspannung vorgegebenen Signalfrequenz, auf Null zu schalten oder zumindest eine Reduktion der Spannung an den Piezokontakten zu erreichen. Mit dem Entladeschalter lassen sich die Frequenz und die Form des Ansteuerungssignals besonders flexibel und weitgehend unabhängig von der Eingangsspannung gestalten.

Gemäß einer alternativen Variante der erfindungsgemäßen Piezo-Ansteuerungsschaltung weist der Entladeschalter im Durchschaltzustand einen elektrischen Widerstand auf. Aus dem elektrischen Widerstand des Entladeschalters und der Kapazität des Piezoaktors ergibt sich das Schaltverhalten bzw. die Umladezeit, mit der die Piezoaktoren von dem Entladeschalter umgeladen werden. Alternativ kann auch seriell zu dem Entladeschalter ein zusätzlicher Widerstand geschaltet sein, der zusammen mit dem Widerstand und der Kapazität des Piezoaktors das Schaltverhalten bzw. die Umladezeit der Piezoaktoren bestimmt.

In einer weiteren bevorzugten Ausgestaltung der Erfindung weist die Piezo-Ansteuerungsschaltung einen zusätzlichen Schalter auf, der seriell zwischen den Entladeschalter und die Piezo-Schnittstelle geschaltet ist und zu dem ein Überbrückungswiderstand parallel geschaltet ist. Mit dem zusätzlichen Schalter lassen sich Unstetigkeiten in der Spannungszeitkurve beheben. Anders ausgedrückt, wird durch den Überbrückungswiderstand eine zusätzliche Zeitkonstante eingeführt, mit der der Verlauf der Spannungszeitkurve des Steuerungssignals beeinflusst werden kann. Im geöffneten Zustand weist der zusätzliche Schalter den Widerstand unendlich auf und der Strom fließt durch den parallel geschalteten Widerstand. Im geschlossenen, d. h. durchgeschalteten Zustand des Schalters weist der Schalter einen Widerstand von annähernd Null auf und der Strom fließt im Wesentlichen durch den Schalter.

Das von der erfindungsgemäßen Piezo-Ansteuerungsschaltung verwendete Spannungssignal kann ein Wechselstromsignal oder ein Drehstromsignal sein. Mit dem Drehstromsignal lassen sich bei der gleichen Grundfrequenz im Vergleich zum Wechselstrom höhere Signalfrequenzen des Steuerungssignals erreichen, da anschaulich ausgedrückt, zwischen den einzelnen Phasen des Drehstroms hin und hergesprungen werden kann.

Bei einer sehr vorteilhaften Variante der Piezo-Ansteuerungsschaltung sind eine Mehrzahl von Piezoaktoren parallel zueinander geschaltet. Bei dieser Schaltungskonstellation kann zum Beispiel eine parallele Fertigungslinie mit einer einzigen Ansteuerungsschaltung realisiert werden. Durch Einsparung zusätzlicher Ansteuerungsschalter ergibt sich nicht nur ein günstiger Kosteneffekt, es wird zudem auch ein exakter Gleichtakt der parallel angesteuerten Einheiten erreicht.

Zusätzlich können die Piezoaktoren auch in eine Mehrzahl von Gruppen von Piezoaktoren eingeteilt sein, wobei jeder der Gruppen zwei Leitungen der Schaltmatrix in Spaltenrichtung zugeteilt sind. Dabei kann die Sync-Kontrollschaltung dazu eingerichtet sein, für jede der Gruppen von Piezoaktoren ein separates Steuerungssignal zu erzeugen, so dass die einzelnen Gruppen von Piezoaktoren unabhängig voneinander ansteuerbar sind. Somit lassen sich mit einer einzigen Ansteuerungsschaltung auch gleichzeitig verschiedene Ansteuerungsmuster realisieren. Beispielsweise können mehrere verschiedene Produktionsschritte mit einer einzigen Ansteuerungsschaltung gesteuert werden.

Die Piezo-Ansteuerungsschaltung kann ferner auch eine Spannungsquelle umfassen, welche an den Eingang angeschlossen ist. Dabei kann zwischen die Spannungsquelle und die Umrichterschaltung ein Trenntransformator geschaltet sein. Der Trenntransformator verhindert zuverlässig einen Massenschluss der Spannungsquelle, der zum Beispiel unbeabsichtigt durch einen Anwender hervorgerufen wird. Somit wird die Sicherheit bei der Bedienung und Wartung der Anordnung erhöht.

In einer besonders vorteilhaften Variante des erfindungsgemäßen Verfahrens wird das Spannungssignal zur Steuerung der Piezoaktoren durch Entladen des spannungsgesteuerten Piezoaktors über einen zusätzlichen, parallel zu der Piezoschnittstelle geschalteten Entladeschalter modifiziert.

Das Spannungssignal zur Steuerung der Piezoaktoren kann dabei auch zusätzlich durch Zuschalten eines seriellen Widerstands modifiziert werden.

In einer besonders vorteilhaften Variante des erfindungsgemäßen Verfahrens werden die Schalter zeitlich synchron mit dem Nulldurchgang des Spannungssignals angesteuert, so dass die Schalter stromlos geschaltet werden können. Bei dieser Art der Ansteuerung ergibt sich ein besonders niedriger Energieverbrauch der Ansteuerungsschaltung.

Alternativ können die Schalter auch zeitlich versetzt zu dem Nulldurchgang des Spannungssignals angesteuert werden, so dass die Polarität der an der Piezo-Schnittstelle anliegenden Spannung variiert. Durch die Variation der Polarität der an den Piezoaktoren anliegenden Spannung kann effektiv eine größere Auslenkung bzw. ein größerer Hub der Piezoaktoren erreicht werden. Dabei wird jedoch vorzugsweise darauf geachtet, dass die an den Piezoaktoren anliegende negative Spannung, auch Bipolarspannung genannt, einen gewissen Wert der Betriebsspannung nicht überschreitet und die Zeit, während der die Bipolarspannung an den Piezoaktoren anliegt, einen Maximalwert nicht überschreitet.

Die Erfindung wird im Folgenden unter Hinweis auf die beigefügten Figuren anhand von Ausführungsbeispielen noch einmal näher erläutert. Dabei sind in den verschiedenen Figuren gleiche oder ähnliche Komponenten mit identischen Bezugsziffern versehen. Es zeigen:
Figur 1 eine Piezo-Ansteuerungsschaltung gemäß einem ersten Ausführungsbeispiel der Erfindung,
Figur 2 ein Schaubild einer Spannungszeitkurve einer an einer Piezoaktor-Anordnung anliegenden Steuerspannung,
Figur 3 ein Schaubild einer Spannungszeitkurve einer an einer Piezoaktor-Anordnung anliegenden Steuerspannung,
Figur 4 ein Schaubild einer bipolaren Spannungszeitkurve einer an einer Piezoaktor-Anordnung anliegenden Steuerspannung,
Figur 5 eine Piezo-Ansteuerungsschaltung gemäß einem zweiten Ausführungsbeispiel der Erfindung,
Figur 6 ein Schaubild einer Spannungszeitkurve einer an einer Piezoaktor-Anordnung anliegenden Steuerspannung, welche von der Piezo-Ansteuerungsschaltung gemäß einem zweiten Ausführungsbeispiel der Erfindung erzeugt wird,
Figur 7 ein Schaubild einer Spannungszeitkurve einer an einer Piezoaktor-Anordnung anliegenden Steuerspannung, welche von der Piezo-Ansteuerungsschaltung gemäß einem zweiten Ausführungsbeispiel der Erfindung erzeugt wird,
Figur 8 eine Piezo-Ansteuerungsschaltung gemäß einem dritten Ausführungsbeispiel der Erfindung.

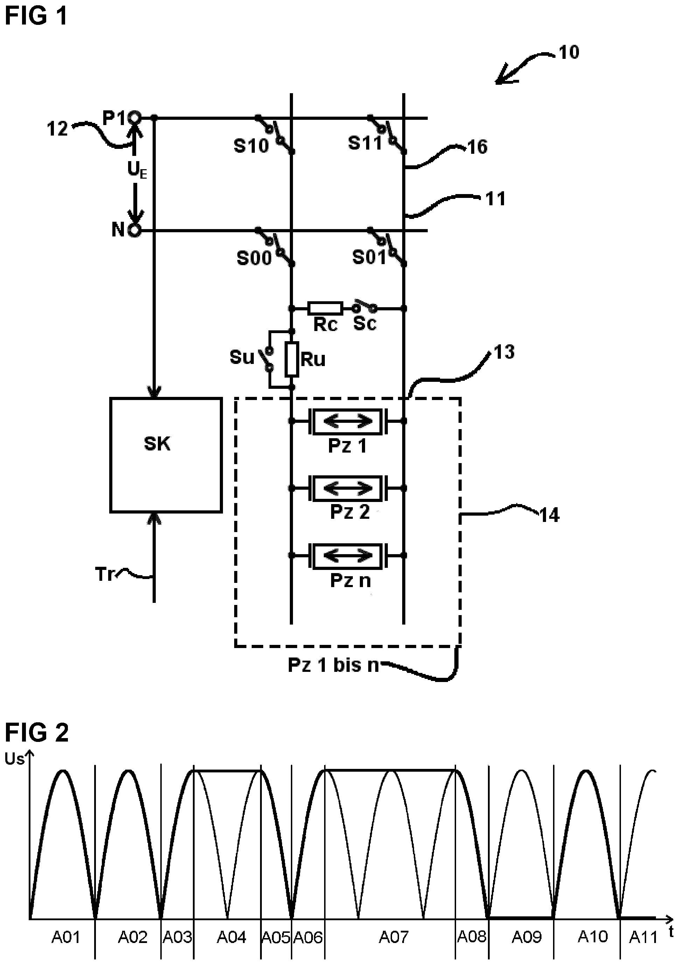

In Figur 1 ist eine Piezoaktor-Einrichtung 10 mit einer Piezo-Ansteuerungsschaltung 11 gemäß einem ersten Ausführungsbeispiel der Erfindung gezeigt. In dem genannten Ausführungsbeispiel wird eine Piezoaktor-Anordnung PZA aus Piezoaktoren Pz 1, Pz 2 ... Pz n angesteuert. Die Piezo-Ansteuerungsschaltung 11 umfasst einen Eingang 12, an dem eine zeitlich veränderliche Spannung U_{E} anliegt. Die zeitlich veränderliche Spannung U_{E} kann beispielsweise von einer Wechselspannungsquelle (nicht gezeigt) erzeugt werden. Dabei kann diese Wechselspannungsquelle im einfachsten Fall ein standardisierter Wechselstromanschluss sein. Der Eingang umfasst einen Phaseneingang P1 und einen Eingang für einen Neutralleiter N. Die am Phaseneingang anliegende Phase P1 ist in diesem Fall beispielsweise ein Phasenstrang einer Netzspannungsleitung eines Stromversorgungsnetzes. Die Piezo-Ansteuerungsschaltung 11 umfasst weiterhin eine Umrichterschaltung 16 mit einer 2x2-Schaltmatrix mit vier elektronischen Schaltern S10, S11, S00, S01, welche matrixartig mit dem Eingang 12 sowie mit einer Piezo-Schnittstelle 13 verschaltet ist. Die Piezo-Schnittstelle 13 ist ihrerseits an eine Piezoaktor-Anordnung 14 mit einer Mehrzahl von zueinander parallel geschalteten Piezoaktoren Pz 1, Pz 2, ... Pz n angeschlossen. Die Parallelschaltung der Piezoaktoren Pz 1, Pz 2, ... Pz n ermöglicht es, die Ansteuerung bzw. den Aufbau der Piezo-Ansteuerungsschaltung 11 der Piezoaktoren besonders einfach und kostengünstig auszulegen, da für eine größere Anzahl von Piezoaktoren nur eine Ansteuerungseinheit bzw. Piezo-Ansteuerungsschaltung 11 benötigt wird. Die Phase der an dem Eingang 12 anliegenden Spannung U_{E} wird von einem Sync-Kontroller SK erfasst und es werden bei einem an dem Sync-Kontroller SK anliegenden Triggersignal Tr gemäß einem Schaltschema passende Ansteuersignale für die elektronischen Schalter S10, S11, S00, S01 erzeugt, um eine bestimmte, an den Piezoaktoren bzw. der Piezoaktor-Anordnung 14 anliegende Spannungszeitkurve zu erzeugen. Die Sync-Kontrollschaltung SK kann zur Übertragung von Steuersignalen an die Schalter S mit den Schaltern S über einzelne, den einzelnen Schaltern S zugeordnete Steuerleitungen verbunden sein. Alternativ ist auch eine Schaltmatrix möglich, über die die Schalter S von der Sync-Kontrollschaltung SK angesteuert werden. Der Übersichtlichkeit halber sind die Steuerleitungen in Figur 1 nicht gezeigt. Durch den periodischen Wechsel der Ansteuerung der elektronischen Schalter S10, S11, S00, S01 in Abhängigkeit von der Phasenlage der Eingangsspannung U_{E} wird eine vorzeichenrichtige Ansteuerung der Piezoaktoren Pz 1, Pz 2, ... Pz n und Energierückspeisung erreicht. Das Schalten der elektronischen Schalter geschieht bei diesem Ausführungsbeispiel bezüglich des Spannungsverlaufs stetig, so dass ein stromloses Schalten ermöglicht wird. Das stromlose Schalten hat den zusätzlichen Effekt, dass die Piezoaktoren als Blindwiderstände betrieben werden können und somit praktisch keine elektrische Energie verbrauchen, da anschaulich die beim Aufladen der Piezoaktoren benötigte Energie aus dem Netz beim Entladen wieder in das Netz zurückgespeist wird. Zusätzlich ist ein Schalter Sc zu den Piezoaktoren Pz 1, Pz 2, ... Pz n bzw. der Piezoaktor-Anordnung 14 parallel geschaltet. Der Schalter Sc kann für ein asynchrones Entladen der Piezoaktoren Pz 1, Pz 2, ... Pz n eingesetzt werden. Unter einem asynchronen Entladen ist ein Entladen zu verstehen, das nicht mit der Phase der Eingangsspannung U_{E} synchron verläuft. Der Schalter Sc weist einen Widerstand Rc auf, der als zu dem Schalter Sc seriell geschalteter Widerstand eingezeichnet ist. Ist der Schalter Sc offen, d. h. nicht durchgeschaltet, so wird die an den Piezoaktoren Pz 1, Pz 2, ... Pz n anliegende Spannung entsprechend der Eingangsspannung U_{E} gesteuert. Ist der Schalter Sc geschlossen, d. h. durchgeschaltet, so fließt zwischen den Kontakten der Piezoaktoren Pz 1, Pz 2, ... Pz n ein Ausgleichstrom, der die zwischen den Kontakten der Piezoaktoren liegende Spannung auf den Wert Null zurückführt. Somit lässt sich mit dem Schalter Sc ein beliebiges Zeitintervall für die Aktivierung der Piezoaktoren festlegen. Weiterhin ist zwischen dem Schalter Sc bzw. dem Widerstand Rc und den Piezoaktoren Pz 1, Pz 2, ... Pz n ein Schalter Su mit einem parallelen Überbrückungswiderstand Ru angeordnet. Der Schalter Su dient zur Überwindung von möglichen Unstetigkeitsstellen in der Kurvensynthese und fügt zusammen mit dem Schalter Sc eine zusätzliche Zeitkonstante hinzu.

In Figur 2 ist eine Spannungszeitkurve einer an einer Piezoaktor-Anordnung 14 bzw. den Piezoaktoren einer Piezoaktor-Anordnung 14 gemäß dem ersten Ausführungsbeispiel anliegenden Steuerspannung Uₛ gezeigt. Das Verhalten der Steuerspannung Uₛ in Abhängigkeit von der Zeit wird allein durch Einschalten und Ausschalten der Schalter S00, S01, S10 und S11 erreicht. Das zugehörige Schaltschema ist in der Tabelle 1 gezeigt. Dabei ist der Schaltzustand "offen" mit "0" gekennzeichnet und der Schaltzustand "geschlossen", d. h. durchgeschaltet, mit "1" gekennzeichnet. In dem Zeitintervall bzw. Abschnitt A01 sind die beiden Schalter S00 und S11 offen und die Schalter S01 und S10 geschlossen. Anders ausgedrückt, liegt die Spannung der an P1 anliegenden positiven Halbwelle an den Piezoaktoren der Piezoaktor-Anordnung 14 derart an, dass jeweils an den linken Anschlüssen der Piezoaktoren, also den Anschlüssen der Piezoaktoren, die mit den Schaltern S00 und S10 in Kontakt stehen, über den Schalter S10 ein positives Potential anliegt, während jeweils an den rechten Anschlüssen der Piezoaktoren, also den Anschlüssen der Piezoaktoren, die mit den Schaltern S01 und S11 in Kontakt stehen, über den Schalter S01 das Potential des Neutralleiters, also im Idealfall das Potential 0 anliegt. Insgesamt liegt in dem Zeitintervall A0 an den Piezoaktoren Pz 1, Pz 2, ... Pz n eine positive Spannung an. Die Zeitdauer, während der die Piezoaktoren aktiviert werden, wird in diesem Fall von der Frequenz der an dem Eingang 12 (siehe Figur 1) anliegenden Eingangsspannung U_{E} bestimmt.

**Tabelle 1**

| **Abschnitt** | **S00** | **S01** | **S10** | **S11** |
|---|---|---|---|---|
| **A01** | 0 | 1 | 1 | 0 |
| **A02** | 1 | 0 | 0 | 1 |
| **A03** | 0 | 1 | 1 | 0 |
| **A04** | 0 | 0 | 0 | 0 |
| **A05** | 1 | 0 | 0 | 1 |
| **A06** | 0 | 1 | 1 | 0 |
| **A07** | 0 | 0 | 0 | 0 |
| **A08** | 0 | 1 | 1 | 0 |
| **A09** | 0 | 0 | 0 | 0 |
| **A10** | 0 | 1 | 1 | 0 |
| **A11** | 0 | 0 | 0 | 0 |

Bei einem Standardstromanschluss würde die Länge des Zeitintervalls A01 bei einer Frequenz von 50 Hz beispielsweise 10 ms betragen. Das in dem Zeitintervall A01 anliegende Signal U_{E} kann als Einzelpuls einer 100 Hz-Halbwellenfolge angesehen werden. Während des Zeitabschnitts A02 wird die Eingangsspannung U_{E} umgepolt, nun liegt an P1 eine negative Spannung an. Damit die Piezoaktoren Pz 1, Pz 2, ... Pz n aber weiterhin vorzeichenrichtig angesteuert werden, wird die Eingangsspannung U_{E} durch Durchschalten der Schalter S00 und S11 und Öffnen der Schalter S01 und S10 invertiert. Somit wird an den Piezoaktoren Pz 1, Pz 2, ... Pz n während des Zeitintervalls A02 derselbe Spannungsverlauf verzeichnet wie während des Zeitabschnitts A01. Anders ausgedrückt, liegt während des Zeitintervalls A02 an den linken Anschlüssen der Piezoaktoren, also den Anschlüssen der Piezoaktoren, die mit den Schaltern S00 und S10 in Kontakt stehen, nun das Potential des Neutralleiters, also im Idealfall das Potential 0 an, während jeweils an den rechten Anschlüssen der Piezoaktoren, also den Anschlüssen der Piezoaktoren, die mit den Schaltern S01 und S11 in Kontakt stehen, das Potential der Phase P1 anliegt, also ein negatives Potential. Insgesamt liegt also auch in dem Zeitabschnitt A02 eine positive Spannung an den Piezoaktoren Pz 1, Pz 2, ... Pz n an. Das Umschalten der Schalter S00, S01, S10 und S11 wird über den bereits genannten Sync-Kontroller SK mit dem Phasenverhalten der Eingangsspannung U_{E} synchronisiert. Dies kann zum Beispiel dadurch realisiert sein, dass die Phase P1 von dem Sync-Kontroller am Eingang 10 detektiert wird und das Auslösen der Schaltsignale an den Schaltern S00, S01, S10 und S11 von dem Sync-Kontroller SK mit diesem Phasensignal abgeglichen wird. Zwischen der Phase P1 und dem Sync-Kontroller SK ist ein Pfeil in Richtung des Sync-Kontroller SK eingezeichnet. Dieser Pfeil symbolisiert, dass die an der Phase P1 anliegende Spannung von dem Sync-Kontroller erfasst wird. Beispielsweise kann eine Leitung zwischen der Phase P1 und dem Sync-Kontroller zum Erfassen des an der Phase P1 anliegenden Spannungssignals angeordnet sein. Das Zeitintervall A03 entspricht einem halben Zeitintervall A01. In dem Zeitintervall A04 werden alle Schalter S00, S01, S10 und S11 geöffnet, so dass die an den Piezoaktoren anliegende Spannung Uₛ für das Zeitintervall A04 festgehalten wird. Das Ausschalten der Schalter S00, S01, S10 und S11 kann zum Beispiel durch ein Triggersignal Tr, das der Sync-Kontroller von einer Steuerungseinrichtung (nicht gezeigt) erhält, ausgelöst werden. Der Sync-Kontroller SK synchronisiert sein Schaltverhalten nun wieder mit der Phase des Eingangssignals U_{E} und löst das Öffnen der Schalter S00, S01, S10 und S11 phasenrichtig aus, nämlich genau dann, wenn das Eingangssignal ein Maximum angenommen hat. Während des Intervalls A04 bleiben die Piezoaktoren Pz 1, Pz 2, ... Pz n aktiviert, d. h. es liegt eine Spannung Uₛ zwischen den Kontakten der Piezoaktoren an. Zu Beginn des Zeitintervalls A05 werden die Schalter S01 und S11 geschlossen, so dass die an den Piezoaktoren Pz 1, Pz 2, ... Pz n anliegende Spannung Uₛ bis zum Ende des Intervalls entsprechend der invertierten Eingangsspannung U_{E} wieder auf 0 zurückgeht. In den Zeitintervallen A03 bis A05 werden quasi zwei Halbwellen zusammengefasst, so dass ein Signalpuls erzeugt wird, der im Vergleich zu den Signalen in den Intervallen A01 und A02 die halbe Frequenz bzw. die doppelte Periode aufweist. In den Intervallen A06 bis A08 wiederholt sich der Vorgang in den Intervallen A03 bis A05 mit der Änderung, dass nun ein längeres Aktivierungsintervall der Piezoaktoren Pz 1, Pz 2, ... Pz n mit einer im Vergleich zu den Zeitintervallen A01 und A02 dreimal so langen Pulszeit bzw. Periode gesteuert wird. In dem Zeitabschnitt A09 werden die Schalter S00, S01, S10 und S11 geöffnet, während die an den Piezoaktoren liegende Spannung Uₛ 0V beträgt. Während dieser Zeitspanne sind die Piezoaktoren Pz 1, Pz 2, ... Pz n deaktiviert. In dem Intervall A10 erfolgt wieder eine Aktivierung der Piezoaktoren Pz 1, Pz 2, ... Pz n und in dem Intervall A11 wieder eine Pause wie in dem Intervall A09.

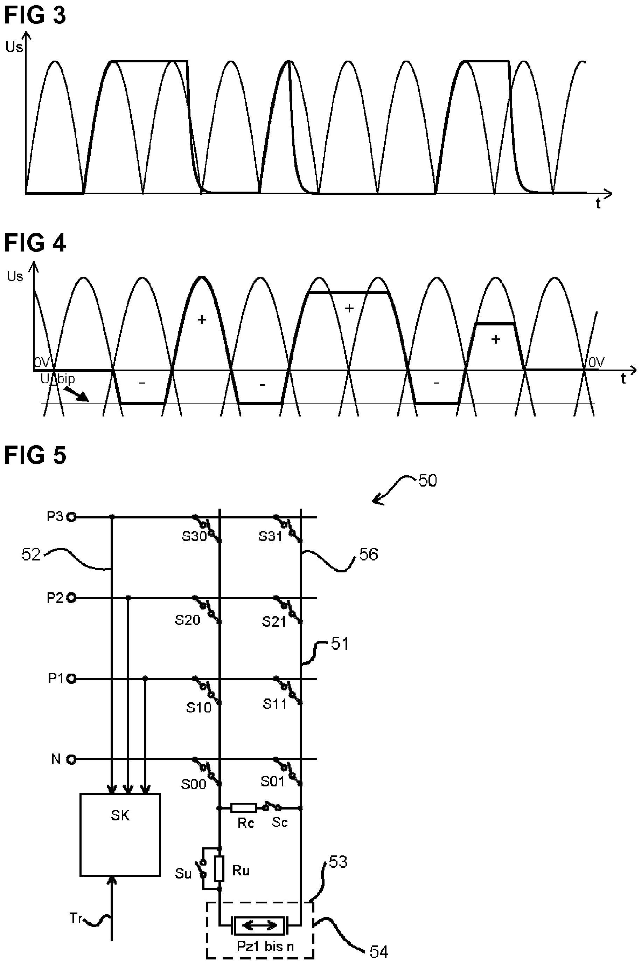

In Figur 3 ist eine Spannungszeitkurve einer an den Piezoaktoren Pz 1, Pz 2, ... Pz n der Piezoaktor-Anordnung 14 gemäß dem ersten Ausführungsbeispiel anliegenden Steuerspannung Uₛ gezeigt, wobei nun die an den Piezoaktoren Pz 1, Pz 2, ... Pz n anliegende Spannung Uₛ mittels eines Chopper-Schalters Sc beeinflusst wird. Durch den Einsatz dieses zusätzlichen Schalters Sc lässt sich eine zeitlich wahlfreie Entladung der Piezoaktoren Pz 1, Pz 2, ... Pz n erzielen. Diese ermöglicht einen Dosierpuls zu einem nach der Aufladung von der Netzfrequenz unabhängigen Zeitpunkt. Beispielsweise wird während der dritten Halbwelle der Eingangsspannung U_{E} der Chopper-Schalter aktiviert und so ein Rückgang der an den Piezoaktoren Pz 1, Pz 2, ... Pz n anliegenden Spannung Uₛ auf den Wert Null etwa bis zu dem Anfang der vierten Halbwelle erreicht. Wie in Figur 3 zu sehen ist, lässt sich unter Verwendung des Schalters Sc in Kombination mit den anderen Schaltern S00 bis S11 sowohl eine Verkürzung der Periode der Signalspannung bzw. Steuerspannung Uₛ als auch eine Verlängerung erreichen.

In Figur 4 ist ein Kurvenverlauf einer Spannungszeitkurve veranschaulicht, welcher angewandt werden kann, wenn ein besonders hoher Hub der Piezoaktoren Pz 1, Pz 2, ... Pz n erzielt werden soll. Der Hub der Piezoaktoren ist abhängig von der Spannungsdifferenz zwischen den Extrema des Steuersignals Uₛ. Daher wird der Hub der Piezoaktoren Pz 1, Pz 2, ... Pz n durch eine Umpolung der Piezoaktoren gesteigert. Die zeitweise an den Piezoaktoren Pz 1, Pz 2, ... Pz n anliegende negative Spannung Uₛ wird auch als Bipolarspannung U_{bip} bezeichnet. Die Bipolarspannung U_{bip} wird durch eine Verschiebung der Ansteuerzeitpunkte der Schalter S00, S01, S10 und S11 erreicht. Bei dem in der Figur 4 gezeigten Beispiel werden bzw. bleiben im Gegensatz zu den in Figur 2 und 3 gezeigten Beispielen während der zweiten Halbwelle, d. h. bei negativer Eingangsspannung U_{E} bzw. negativer Phase P1, die Schalter S01 und S10 durchgeschaltet, das heißt, die negative, am Eingang anliegende Spannung U_{E} wird auf die Schnittstelle 13 zwischen der Piezo-Ansteuerschaltung 11 und der Piezoaktor-Anordnung 14 mit den Piezoaktoren Pz 1, Pz 2, ... Pz n übertragen, so dass zunächst auch keine Gleichrichtung erfolgt, wodurch ein Umpolen der Piezoaktoren Pz 1, Pz 2, ... Pz n erreicht wird. Anders ausgedrückt, liegt nun an dem linken Anschluss der Piezoaktoren Pz 1, Pz 2, ... Pz n das negative Potential der negativen Halbwelle der Phase P1 an. Es liegt also eine negative Spannung an den Piezoaktoren an, die, um einer Beschädigung der Piezoaktoren vorzubeugen, nur kurz anliegen sollte und auf etwa ¼ der Betriebsspannung beschränkt werden sollte. Während der zweiten Halbwelle wird in der Figur 4 ab einem Zeitpunkt, bei dem der Wert der Eingangsspannung U_{E} einen vorbestimmten Schwellwert erreicht, die Spannung an den Piezoaktoren Pz 1, Pz 2, ... Pz n kontant gehalten, indem die Schalter S01 und S10 geöffnet werden. Dieser Zustand wird beibehalten, bis der Spannungswert der Eingangsspannung U_{E} bzw. deren Absolutwert wieder den vorbestimmten Schwellwert unterschreitet. Anschließend werden die Schalter S01 und S10 durchgeschaltet, so dass wieder die Eingangsspannung U_{E} an den Piezoaktoren Pz 1, Pz 2, ... Pz n anliegt.

In Figur 5 ist eine Piezoaktor-Einrichtung 50 mit einer Piezo-Ansteuerungsschaltung 51 gemäß einem zweiten Ausführungsbeispiel der Erfindung veranschaulicht. Die Piezoaktor-Einrichtung 50 umfasst analog zu der Piezoaktor-Einrichtung 10 einen Eingang 52. In diesem Fall ist die Ansteuerung der Piezoaktoren Pz 1, Pz 2, ... Pz n auf drei Phasen erweitert. Es wird also als Eingangsspannung U_{E} eine dreiphasige Spannung angelegt. Im Vergleich zu dem ersten Ausführungsbeispiel lässt sich damit die erzeugbare Kurvenvielfalt erhöhen und die Frequenz, mit der die Schaltzustände der Piezoaktoren geändert werden können, steigern. Anders gewendet, kann bei um 2/3 niedrigerer Frequenz ein Ansteuerungssignal mit der gleichen Frequenz wie bei dem ersten Ausführungsbeispiel erzeugt werden. Aufgrund der Tatsache, dass der das Signal störende Jitter proportional zu der Grundfrequenz ist, kann diese Störgröße bei dem zweiten Ausführungsbeispiel entsprechend um 2/3 reduziert werden. Die Piezoaktor-Einrichtung 50 ist analog zu der Piezoaktor-Einrichtung 10 in Figur 1 aufgebaut. Anders als in der Figur 1 umfasst der Eingang der Piezoaktor-Einrichtung 50 jedoch drei Phasen P1, P2 und P3, welche über eine Umrichterschaltung 56 mit einer 4x2-Schaltmatrix mit den Schaltern S00, S01, S10, S11, S20, S21, S30, S31 über eine Piezo-Schnittstelle 53 mit einer Piezoaktor-Anordnung 54 gekoppelt sind, die eine Mehrzahl von parallel geschalteten Piezoaktoren Pz 1 bis Pz n umfasst. Der Sync-Kontroller SK ist nun mit den Phasen P1, P2 und P3 gekoppelt, um alle drei Phasen der anliegenden Spannung U_{E} zu detektieren. Synchron zu der dreiphasigen Eingangsspannung U_{E} steuert nun der Sync-Kontroller SK die Schalter S00, S01, S10, S11, S20, S21, S30, S31 der 4x2-Schaltmatrix, so dass an den Piezoaktoren Pz 1 bis Pz n jeweils eine positive Spannung U_{S} mit der gewünschten Form bzw. dem gewünschten zeitlichen Verlauf anliegt. Wie bei dem ersten Ausführungsbeispiel kann die an den Piezoaktoren Pz 1 bis Pz n anliegende Spannung Uₛ mittels eines Chopper-Schalters Sc beeinflusst werden. Durch den Einsatz dieses zusätzlichen Schalters Sc lässt sich eine zeitlich wahlfreie Entladung der Piezoaktoren Pz 1, Pz 2, ... Pz n erzielen. Wie bereits erwähnt, ermöglicht dies einen Dosierpuls zu einem nach der Aufladung von der Netzfrequenz unabhängigen Zeitpunkt.

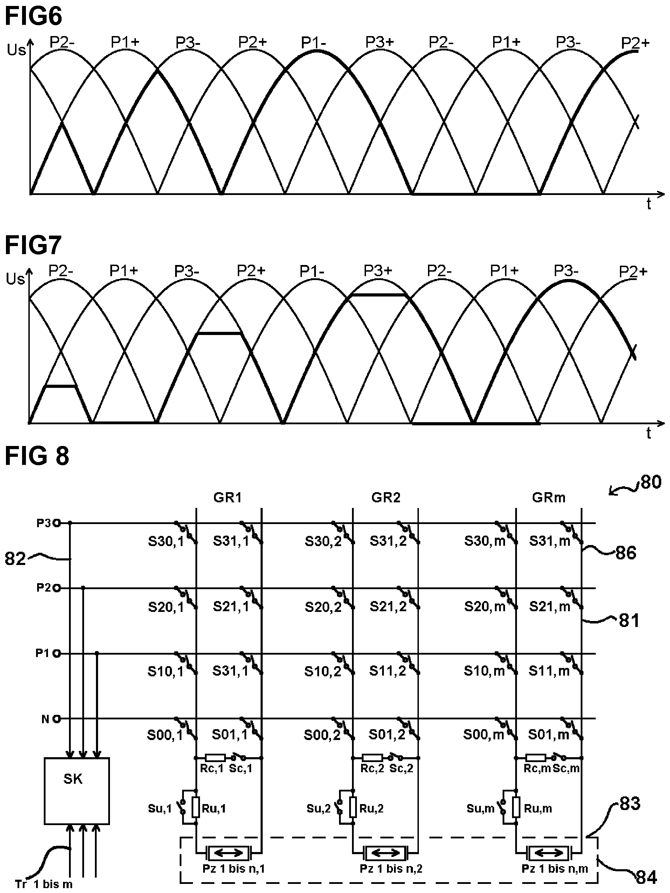

In Figur 6 ist eine Kurvenfolge eines zeitlichen Spannungsverlaufs der Steuerspannung Uₛ veranschaulicht, welcher von einer Piezo-Ansteuerungsschaltung 51 gemäß dem zweiten Ausführungsbeispiel erzeugt wird. Beispielsweise beginnt die Kurve mit dem Durchschalten der Schalter S10 und S01, während alle anderen Schalter geöffnet sind. Bei einer Phase von P1 von 30°, bei der die Absolutwerte der Spannung der Phasen P1 und P3 gleich sind, wird nun zur Phase P3 gesprungen, indem der Schalter S10 geöffnet wird und dafür der Schalter S30 durchgeschaltet wird. Die Spannung der Phase P3 ist positiv, so dass an den Piezoaktoren Pz 1 bis Pz n weiterhin eine positive Spannung anliegt. Bei dem Übergang der Phase P3 am Eingang von der positiven Halbwelle zur negativen Halbwelle werden nun die Schalter S31 und S00 geschlossen und dafür die Schalter S01 und S30 geöffnet, so dass nun an den Piezoaktoren Pz 1 bis Pz n weiterhin eine positive Spannung anliegt. Bei einer Phase von P1 von 120°, bei der die Absolutwerte der Spannung der Phasen P1 und P3 gleich sind, wird nun wieder zur Phase P1 zurückgesprungen, indem die Schalter S31 und S00 geöffnet werden und dafür die Schalter S10 und S01 durchgeschaltet werden. Während der negativen Halbwelle der Phase P1 werden die Schalter S10 und S01 geöffnet und dafür die Schalter S11 und S00 durchgeschaltet, so dass an den Piezoaktoren Pz 1 bis Pz n weiterhin eine positive Spannung anliegt. Bei dem Übergang der Phase P1 von der negativen Halbwelle zur positiven Halbwelle werden nun alle Schalter geöffnet, so dass die an den Piezoaktoren anliegende Spannung Uₛ den Wert Null beibehält. Schließlich wird die Spannungskurve auf der zweiten Phase P2 fortgeführt, indem die beiden Schalter S20 und S01 durchgeschaltet werden und die übrigen Schalter geöffnet bleiben. Durch Springen zwischen den einzelnen Phasen an verschiedenen Kreuzungspunkten der einzelnen Phasen werden verschiedene Signalformen mit unterschiedlicher Pulsdauer und unterschiedlicher Amplitude erreicht.

In Figur 7 ist eine Kurvenfolge eines Spannungsverlaufs U_{S} in Abhängigkeit von der Zeit gezeigt, welcher ebenfalls mit einer Piezo-Schaltungsanordnung 51 gemäß dem zweiten Ausführungsbeispiel realisiert werden kann. Dabei werden die Amplituden der an den Piezoaktoren Pz 1 bis Pz n anliegenden Spannungen Uₛ auf bestimmte Spannungswerte skaliert. Die Skalierung erfolgt durch ein Festhalten der an den Piezoaktoren Pz 1 bis Pz n anliegenden Spannungen Uₛ bei bestimmten Werten. Dies wird durch Öffnen der jeweils aktuell geschlossenen, d. h. durchgeschalteten Schalter S bei einem Schwellwert der Spannungsamplitude bzw. bei einem bestimmten Wert der dazu korrespondierenden Phase der Eingangsspannung erreicht. Zunächst wird die Steuerspannung Uₛ analog zu der Figur 6 mittels Durchschaltens der Schalter S10 und S01, während alle anderen Schalter geöffnet sind, erzeugt. Bei einer Phase von P1 von etwa 15° werden die Schalter S10 und S01 geöffnet, so dass nun der gerade erreichte Spannungswert Uₛ konstant bleibt. Bei einer Phase von P1 von etwa 45° wird auf die positive Halbwelle von P3 gewechselt, wobei der Schalter S30 und der Schalter S01 durchgeschaltet werden. Bei dem Nulldurchgang der Phase P3 werden die Schalter S30 und S01 geöffnet, so dass nun die Piezoaktoren deaktiviert bleiben. Als nächstes wird auf die positive Halbwelle der Phase P2 gewechselt, indem der Schalter S20 und der Schalter S01 durchgeschaltet werden. Bei einem vorbestimmten Schwellwert der Steuerspannung Uₛ werden die Schalter S20 und S01 wieder geöffnet, so dass der Schwellwert als Steuerspannung beibehalten wird, bis der Absolutwert der Spannung der Phase P3 gleich dem erreichten Schwellwert der Steuerspannung Uₛ ist. Nun wird auf die negative Halbwelle der Phase P3 gewechselt, indem die Schalter S31 und S00 durchgeschaltet werden. Bei dem Nulldurchgang der Phase P3 bzw. dem Übergang zur positiven Halbwelle wird die Steuerspannung Uₛ positiv gehalten, indem nun die Schalter S31 und S00 geöffnet werden und stattdessen die Schalter S30 und S01 durchgeschaltet werden. Bei einem vorbestimmten Schwellwert der Steuerspannung Uₛ werden die Schalter S30 und S01 geöffnet, so dass der Schwellwert als Steuerspannung beibehalten wird, bis die Eingangsspannung U_{E} den vorbestimmten Schwellwert wieder erreicht. An dieser Stelle wird wieder auf die positive Halbwelle der Phase P3 zurückgewechselt, indem die Schalter S30 und S01 wieder durchgeschaltet werden. Bei dem Nulldurchgang der Spannung Uₛ, d. h. dem Übergang zur negativen Halbwelle der Phase P3, werden die Schalter S30 und S01 geöffnet und die Schalter S31 und S00 durchgeschaltet, wodurch die am Eingang liegende negative Spannung U_{E} in eine positive Steuerspannung Uₛ an den Piezoaktoren invertiert wird.

In Figur 8 ist eine Piezoaktor-Einrichtung 80 gemäß einem dritten Ausführungsbeispiel der Erfindung gezeigt. Die Piezoaktor-Einrichtung 80 umfasst ebenfalls eine Piezo-Ansteuerungsschaltung 81 und eine Piezoaktor-Anordnung 84, die mit einer Piezo-Schnittstelle 83 miteinander gekoppelt sind. Weiterhin umfasst die Piezo-Ansteuerungsschaltung 81 einen Eingang 82, an dem ein Eingangssignal U_{E} anliegt. Die Umrichterschaltung 86 der Anordnung 80 gemäß dem dritten Ausführungsbeispiel ist nun im Vergleich zu der Anordnung 50 gemäß dem zweiten Ausführungsbeispiel dahingehend erweitert, dass nun zusätzliche 2m-2 Spalten zu der Schaltmatrix des zweiten Ausführungsbeispiels hinzugefügt wurden, um jetzt insgesamt m Ventilgruppen GR1 bis GRm unabhängig voneinander ansteuern zu können. Zum unabhängigen Steuern der den einzelnen Gruppen GR1 bis GRm zugehörigen Schaltergruppen i, welche die Schalter S00,i, S01,i, S10,i, S11,i, S20,i, S21,i, S30,i, S31,i, für i= 1 bis m, umfassen, werden nun m voneinander unabhängige Triggersignale Tr1 bis m an den Sync-Kontroller SK gesendet. In Abhängigkeit von dem Zeitpunkt der Triggersignale werden nun die einzelnen Gruppen von Piezoaktoren Pz 1 bis Pz n,i, wobei i = 1 bis m, zu unterschiedlichen Zeitpunkten angesteuert. Denkbar wäre zum Beispiel das Ausführen von unterschiedlichen zeitlich versetzen Arbeitsschritten mit verschiedenen Dosiereinrichtungen bzw. das gleichzeitige Durchführen von verschiedenen Arbeitsschritten in verschiedenen Gruppen von Dosierventilen, wobei nur eine einzige Piezo-Ansteuerungsschaltung 81 benötigt wird. Analog zu den Anordnungen in Figur 1 und Figur 5 umfasst die Piezoaktor-Einrichtung 80 in Figur 8 für jede der Ventilgruppen jeweils einen parallelen Schalter Sc,i und einen seriellen Schalter Su,i, wobei i = 1 bis m ist.

Um Störungen bzw. Unfälle zu vermeiden, kann es weiterhin sinnvoll sein, zwischen den Eingang der beschriebenen Ansteuerschaltungen 11, 51, 81 und die Spannungsquelle einen Trenntransformator zu schalten. Die galvanische Trennung der Piezoaktoren und des Netzanschlusses verhindert den Fluss größerer Ströme, falls ein Anwender mit den Piezoaktoren in Kontakt kommt, während diese an eine Spannungsquelle bzw. ein Stromnetz angeschlossen sind. Falls die Spannungsquelle Drehstrom bzw. eine dreiphasige Spannung liefert, ist es sinnvoll, einen Transformator zu wählen, bei welchem die Primärwicklung in Dreiecksschaltung und die Sekundärwicklung in Sternschaltung ausgeführt ist. Durch diese Art der Beschaltung wird sekundärseitig ein Nullleiter erzeugt, d. h. die Spannungen auf dem Neutralleiter ergeben stets 0, so dass dessen volle Belastbarkeit sichergestellt ist.

Um eine variable Ansteuerspannung zu erzielen, kann dem Trenntransformator zusätzlich ein Regeltransformator nachgeschaltet sein, wobei bei der Variante mit Drehstrom drei auf einer Achse gekoppelte Regeltransformatoren geschaltet werden.

Sollten höhere Eingangsfrequenzen als die zur Verfügung stehen Frequenzen, beispielsweise von 50 oder 60 Hz, als Eingangsspannungsfrequenzen gefordert sein, kann zusätzlich ein Wechselrichter vor den Eingang der beschriebenen Ansteuerungsschaltung geschaltet werden, mit dem von der Netzfrequenz unabhängig die gewünschte Spannungsfrequenz erzeugt wird.

Es wird abschließend noch einmal darauf hingewiesen, dass es sich bei den vorhergehend detailliert beschriebenen Piezoaktor-Einrichtungen und Piezo-Ansteuerungsschaltungen lediglich um Ausführungsbeispiele handelt, welche vom Fachmann in verschiedenster Weise modifiziert werden können, ohne den Bereich der Erfindung zu verlassen. Weiterhin schließt die Verwendung der unbestimmten Artikel "ein" bzw. "eine" nicht aus, dass die betreffenden Merkmale auch mehrfach vorhanden sein können.

### Bezugszeichenliste

10, 50, 80 Piezoaktor-Einrichtung
11, 51, 81 Piezo-Ansteuerungsschaltung
12, 52, 82 Eingang
13, 53, 83 Piezo-Schnittstelle
14, 54, 84 Piezoaktor-Anordnung
16, 56, 86 Umrichterschaltung
A01.. A11 Zeitintervall
GR1... GRm Gruppen von Piezoelementen
N Neutralleiter
P1, P2, P3 Phase
Pz 1, Pz 2 ... Pz n Piezoelemente
Pz 1...Pz n,i Piezoelement der i-ten Ventilgruppe
Rc Widerstand
Ru Überbrückungswiderstand
S, S10, S11, S00, S01, S20, S21, S30, S31 elektronische Schalter
S00,i, S01,i, S10,i, S11,i, S20,i, S21,i, S30,i, S31,i elektronische Schalter der i-ten Schaltergruppe
Sc Schalter/Chopperschalter
SK Sync-Kontroller
Su serieller Schalter
Tr, Tr1 ... Trm Triggersignal
U_{bip} Bipolarspannung
U_{E} Eingangsspannung
Uₛ Steuerspannung/an den Piezoelementen liegende Spannung

## Patentansprüche

1. Piezo-Ansteuerungsschaltung (11, 51, 81), aufweisend
- einen Eingang (12), an welchem ein zeitlich veränderliches Spannungssignal (U_{E}) bereitgestellt wird,
- eine Piezo-Schnittstelle (13, 53, 83) zum Anschluss von Kontakten einer Piezoaktor-Anordnung (14, 54, 84) mit mindestens einem spannungsgesteuerten Piezoaktor (Pz),
- eine Sync-Kontrollschaltung (SK), welche dazu eingerichtet ist, die Phasenlage des Spannungssignals (U_{E}) zu detektieren,
- eine Umrichterschaltung (16, 56, 86) zwischen dem Eingang (12) und der Piezo-Schnittstelle (13, 53, 83),
wobei die Sync-Kontrollschaltung (SK) dazu eingerichtet ist, in Abhängigkeit von der Phasenlage des Spannungssignals (U_{E}) die Umrichterschaltung (16, 56, 86) derart anzusteuern, dass an der Piezo-Schnittstelle eine Steuerspannung (Uₛ) mit einer vorbestimmten Spannungszeitkurve anliegt, **dadurch gekennzeichnet, dass** die Spannungszeitkurve der Steuerspannung (U_{S}) sich ergibt, indem Abschnitte aus der Spannungskurve des Spannungssignals (U_{E}) herausgeschnitten und zusammengefügt werden.

2. Piezo-Ansteuerungsschaltung (11, 51, 81) nach Anspruch 1, wobei die Umrichterschaltung (15, 56, 86) eine Schaltmatrix umfasst, mit einer Mehrzahl von in Zeilenrichtung verlaufenden Leitungen, einer Mehrzahl von in Spaltenrichtung verlaufenden Leitungen und einer Mehrzahl von Schaltern (S), die an den Kreuzungspunkten der Schaltmatrix angeordnet sind und jeweils eine in Zeilenrichtung verlaufende Leitung mit einer in Spaltenrichtung verlaufenden Leitung verbinden, wobei die Mehrzahl von Schaltern (S) zur Steuerung der Schalter (S) mit einem Steuerungssignal an die Sync-Kontrollschaltung (SK) angeschlossen sind.

3. Piezo-Ansteuerungsschaltung (11, 51, 81) nach einem der Ansprüche 1 oder 2, ferner aufweisend einen Entladeschalter (Sc), der parallel zu der Piezo-Schnittstelle geschaltet ist.

4. Piezo-Ansteuerungsschaltung (11, 51, 81) nach Anspruch 3, wobei der Entladeschalter (Sc) in Reihe mit einem Widerstand (Rc) geschaltet ist.

5. Piezo-Ansteuerungsschaltung (11, 51, 81) nach einem der Ansprüche 3 bis 4, ferner aufweisend einen zusätzlichen Schalter (Su), der seriell zwischen den Entladeschalter (Sc) und die Piezo-Schnittstelle (13, 53, 83) geschaltet ist und zu dem ein Überbrückungswiderstand (Ru) parallel geschaltet ist.

6. Piezo-Ansteuerungsschaltung (11, 51, 81) nach einem der Ansprüche 1 bis 5, wobei das Spannungssignal (U_{E}) ein Wechselstromsignal oder ein Drehstromsignal ist.

7. Piezo-Ansteuerungsschaltung (11, 51, 81) nach einem der Ansprüche 1 bis 6, wobei die Piezo-Schnittstelle (13, 53, 83) derart ausgebildet ist, dass eine Mehrzahl von Piezoaktoren (Pz) parallel zueinander schaltbar sind.

8. Piezo-Ansteuerungsschaltung (81) nach einem der Ansprüche 2 bis 7, wobei die Piezo-Schnittstelle eine Mehrzahl von Anschlüssen für eine Mehrzahl von Gruppen (GR1 bis GRm) von Piezoaktoren umfasst, wobei jeder der Gruppen (GR1 bis GRm) von Piezoaktoren zwei Leitungen in Spaltenrichtung zugeteilt sind.

9. Piezo-Ansteuerungsschaltung (81) nach Anspruch 8, wobei die Sync-Kontrollschaltung (SK) dazu eingerichtet ist, für jede der Gruppen (GR1 bis GRm) von Piezoaktoren (Pz) ein separates Ansteuerungssignal zu erzeugen, so dass die einzelnen Gruppen (GR1 bis GRm) von Piezoaktoren unabhängig voneinander ansteuerbar sind.

10. Piezo-Ansteuerungsschaltung (11, 51, 81) nach einem der Ansprüche 1 bis 9, ferner aufweisend eine Spannungsquelle, welche an den Eingang (12, 52, 82) angeschlossen ist und/oder wobei zwischen die Spannungsquelle und die Umrichterschaltung (16, 56, 86) ein Trenntransformator geschaltet ist.

11. Verfahren zur Ansteuerung einer Piezoaktor-Anordnung (14, 54, 84), aufweisend mindestens die Schritte:
- Empfangen eines Spannungssignals (U_{E}),
- Zerlegen und Zusammenfügen der Kurvenabschnitte des Spannungssignals (U_{E}) durch Umpolen des Spannungssignals (U_{E}) gemäß einem vorbestimmten Schaltschema,
- Anlegen des umgepolten Spannungssignals als Steuerspannung (Uₛ) an eine Piezo-Schnittstelle (13, 53, 83) zum Anschluss von Kontakten einer Piezoaktor-Anordnung (14, 54, 84) mit mindestens einem spannungsgesteuerten Piezoaktor (Pz).

12. Verfahren nach Anspruch 11, wobei die Steuerspannung (Uₛ) durch Entladen der Piezoaktoren (Pz) über einen zusätzlichen, parallel zu der Piezoschnittstelle (13, 53, 83) geschalteten Entladeschalter (Sc) modifiziert wird und/oder wobei die Steuerspannung (Uₛ) zusätzlich durch Zuschalten eines seriellen Widerstands (Ru) modifiziert wird.

13. Verfahren nach einem der Ansprüche 11 oder 12, wobei die Schalter (S) zeitlich versetzt zu dem Nulldurchgang des Spannungssignals (U_{E}) angesteuert werden, so dass die Polarität der an der Piezo-Schnittstelle (13, 53, 83) anliegenden Steuerspannung (Uₛ) variiert.

14. Piezoaktor-Einrichtung (10, 50, 80) aufweisend eine Piezoaktor-Anordnung (14, 54, 84) und eine Piezo-Ansteuerungsschaltung (11, 51, 81) nach einem der Ansprüche 1 bis 10.

15. Dosierventil, aufweisend eine Piezoaktor-Einrichtung (10, 50, 80) nach Anspruch 14.

## Claims

1. Piezoelectric control circuit (11, 51, 81), comprising
- an input (12), at which a time variable voltage signal (U_{E}) is provided,
- a piezoelectric interface (13, 53, 83) for connecting contacts of a piezoelectric actuator arrangement (14, 54, 84) to at least one voltage-controlled piezoelectric actuator (Pz);
- a sync monitoring circuit (SK) which is configured to detect the phase angle of the voltage signal (U_{E}),
- a converter circuit (16, 56, 86) between the input (12) and the piezoelectric interface (13, 53, 83),
wherein the sync monitoring circuit (SK) is configured to control the converter circuit (16, 56, 86) in dependence on the phase angle of the voltage signal (U_{E}) in such a way that a control voltage (U_{S}) with a predetermined voltage time curve is applied at the piezoelectric interface, **characterized in that** the voltage time curve of the control voltage (U_{S}) is derived by extracting sections from the voltage curve of the voltage signal (U_{E}) and combining them.

2. Piezoelectric control circuit (11, 51, 81) according to Claim 1,
wherein the converter circuit (15, 56, 86) comprises a switching matrix having a plurality of lines running in the line direction, a plurality of lines running in the column direction and a plurality of switches (S), which are arranged at the intersection points of the switching matrix and which each connect a line running in the line direction to a line running in the column direction, wherein in order to control the switches (S) with a control signal the plurality of switches (S) are connected to the sync monitoring circuit (SK).

3. Piezoelectric control circuit (11, 51, 81) according to any one of Claims 1 or 2,
further comprising a discharge switch (Sc), which is connected in parallel with the piezoelectric interface.

4. Piezoelectric control circuit (11, 51, 81) according to Claim 3,
wherein the discharge switch (Sc) is connected in series with a resistor (Rc).

5. Piezoelectric control circuit (11, 51, 81) according to any one of Claims 3 to 4,
further comprising an additional switch (Su), which is connected in series between the discharge switch (Sc) and the piezoelectric interface (13, 53, 83) and with which a bypass resistor (Ru) is connected in parallel.

6. Piezoelectric control circuit (11, 51, 81) according to any one of Claims 1 to 5,
wherein the voltage signal (U_{E}) is an AC signal or a three-phase signal.

7. Piezoelectric control circuit (11, 51, 81) according to any one of Claims 1 to 6,
wherein the piezoelectric interface (13, 53, 83) is designed in such a way that a plurality of piezoelectric actuators (Pz) can be connected in parallel with each other.

8. Piezoelectric control circuit (81) according to any one of Claims 2 to 7,
wherein the piezoelectric interface comprises a plurality of connections for a plurality of groups (GR1 to GRm) of piezoelectric actuators, wherein each of the groups (GR1 to GRm) of piezoelectric actuators is allocated two lines in the column direction.

9. Piezoelectric control circuit (81) according to Claim 8,
wherein the sync monitoring circuit (SK) is configured to generate a separate control signal for each of the groups (GR1 to GRm) of piezoelectric actuators (Pz), so that the individual groups (GR1 to GRm) of piezoelectric actuators can be controlled independently of each other.

10. Piezoelectric actuation circuit (11, 51, 81) according to any one of Claims 1 to 9,
further comprising a voltage source which is connected to the input (12, 52, 82) and/or wherein an isolation transformer is connected between the voltage source and the converter circuit (16, 56, 86).

11. Method for controlling a piezoelectric arrangement (14, 54, 84), comprising at least the steps of:
- receiving a voltage signal (U_{E}),
- segmenting and combining the curve sections of the voltage signal (U_{E}) by reversing the polarity of the voltage signal (U_{E}) in accordance with a predetermined circuit diagram,
- applying the reversed-polarity voltage signal as a control voltage (U_{S}) to a piezoelectric interface (13, 53, 83) for connecting contacts of a piezoelectric actuator arrangement (14, 54, 84) to at least one voltage-controlled piezoelectric actuator (Pz).

12. Method according to Claim 11,
wherein the control voltage (U_{S}) is modified by discharging the piezoelectric actuators (Pz) via an additional discharge switch (Sc) connected in parallel with the piezoelectric interface (13, 53, 83) and/or wherein the control voltage (U_{S}) is additionally modified by connecting a series resistor (Ru).

13. Method according to any one of Claims 11 or 12,
wherein the switches (S) are controlled with a time delay relative to the zero crossing of the voltage signal (U_{E}), so that the polarity of the control voltage (U_{S}) applied to the piezoelectric interface (13, 53, 83) varies.

14. Piezoelectric device (10, 50, 80) comprising a piezoelectric arrangement (14, 54, 84) and a piezoelectric control circuit (11, 51, 81) according to any one of Claims 1 to 10.

15. Metering valve, comprising a piezoelectric device (10, 50, 80) according to Claim 14.

## Revendications

1. Circuit de commande piézo-électrique (11, 51, 81), présentant
- une entrée (12), à laquelle est fourni un signal de tension variable temporellement (U_{E}),
- une interface piézo-électrique (13, 53, 83) pour la connexion des contacts d'un arrangement d'actionneur piézo-électrique (14, 54, 84) avec au moins un actionneur piézo-électrique commandé par tension (Pz),
- un circuit de contrôle de sync (SK), qui est conçu afin de détecter la position de phase du signal de tension (U_{E}),
- un circuit d'onduleur (16, 56, 86) entre l'entrée (12) et l'interface piézo-électrique (13, 53, 83),
dans lequel le circuit de contrôle de sync (SK) est conçu afin de commander en fonction de la position de phase du signal de tension (U_{E}) le circuit d'onduleur (16, 56, 86) de telle sorte que au niveau de l'interface piézo-électrique une tension de commande (Uₛ) avec une courbe temporelle de tension prescrite soit présente, **caractérisé en ce que** la courbe temporelle de tension de la tension de commande (U_{S}) résulte, en découpant et assemblant des portions de la courbe de tension du signal de tension (U_{E}).

2. Circuit de commande piézo-électrique (11, 51, 81) selon la revendication 1, dans lequel le circuit d'onduleur (15, 56, 86) comprend une matrice de commutation, avec une pluralité de lignes s'étendant dans la direction de rangée, une pluralité de lignes s'étendant dans la direction de colonne et une pluralité de commutateurs (S), qui sont disposés au niveau des points de croisement de la matrice de commutation et relient respectivement une ligne s'étendant dans la direction de rangée avec une ligne s'étendant dans la direction de colonne, dans lequel la pluralité de commutateurs (S) à des fins de commande du commutateur (S) sont connectés avec un signal de commande au circuit de contrôle de sync.

3. Circuit de commande piézo-électrique (11, 51, 81) selon une des revendications 1 ou 2, présentant en outre un commutateur de décharge (Sc), qui est branché parallèlement à l'interface piézo-électrique.

4. Circuit de commande piézo-électrique (11, 51, 81) selon la revendication 3, dans lequel le commutateur de décharge (Sc) est branché en série avec une résistance.

5. Circuit de commande piézo-électrique (11, 51, 81) selon une des revendications 3 à 4, présentant en outre un commutateur supplémentaire (Su), qui est branché en série entre le commutateur de décharge (Sc) et l'interface piézo-électrique (13, 53, 83) et auquel est branchée en parallèle une résistance de shuntage (Ru).

6. Circuit de commande piézo-électrique (11, 51, 81) selon une des revendications 1 à 5, dans lequel le signal de tension (U_{E}) est un signal de courant alternatif ou un signal de courant triphasé.

7. Circuit de commande piézo-électrique (11, 51, 81) selon une des revendications 1 à 6, dans lequel les interfaces piézo-électrique (13, 53, 83) sont configurés de telle sorte qu'une pluralité d'actionneurs piézo-électriques (Pz) puissent être branchés en parallèle les uns aux autres.

8. Circuit de commande piézo-électrique (81) selon une des revendications 2 à 7, dans lequel l'interface piézo-électrique comprend une pluralité de branchements pour une pluralité de groupes (GR1 à GRm) d'actionneurs piézo-électrique, dans lequel chacun des groupes (GR1 à GRm) d'actionneur piézo-électriques se voit attribuer deux lignes dans la direction de colonne.

9. Circuit de commande piézo-électrique (81) selon la revendication 8, dans lequel le circuit le contrôle de sync (SK) est conçu afin de, pour chacun des (GR1 à GRm) d'actionneurs piézo-électriques (Pz), générer un signal de commande séparée, de sorte que les groupes individuels (GR1 à GRm) d'actionneurs piézo-électriques puissent être commandée indépendamment les uns des autres.

10. Circuit de commande piézo-électrique (11, 51, 81) selon une des revendications 1 à 9, présentant en outre une source de tension, qui est connectée à l'entrée (12, 52, 82) et/ou dans lequel entre la source de tension et le circuit d'onduleur (16, 56, 86) un transformateur de séparation est branché.

11. Procédé de commande d'un arrangement d'actionneur piézo-électrique (14, 54, 84), présentant moins les étapes consistant à :
- recevoir un signal de tension (U_{E}),
- décomposer et assembler les portions de courbe du signal de tension (U_{E}) par inversion de la polarité du signal de tension (U_{E}) selon un schéma de commutation prescrit,
- appliquer le signal de tension à polarité inversée comme tension de commande (Uₛ) à une interface piézo-électrique (13, 53, 83) pour le branchement des contacteurs d'un arrangement d'actionneur piézo-électrique (14, 54, 84) avec au moins un actionneur piézo-électrique commandé par tension (Pz).

12. Procédé selon la revendication 11, dans lequel le circuit de commande (Uₛ) est modifié par la décharge des actionneurs piézo-électriques (Pz) par l'intermédiaire d'un commutateur de décharge (Sc) branché en parallèle aux interfaces piézo-électrique (13, 53, 83) et/ou dans lequel la tension de commande (Uₛ) est modifié en outre par l'activation d'une résistance en série (Ru).

13. Procédé selon une des revendications 11 ou 12, dans lequel le commutateur (S) est commandé en étant décalé temporellement par rapport au passage zéro du signal de tension (U_{E}), de sorte que la polarité de la tension de commande (Uₛ) appliquée à l'interface piézo-électrique (13,53,83) varie.

14. Dispositif d'actionneur piézo-électrique (10, 50, 80) présentant un arrangement d'actionneur piézo-électrique (14, 54, 84) et un circuit de commande piézo-électrique (11, 51, 81) selon une des revendications 1 à 10.

15. Valve de dosage, présentant un dispositif d'actionneur piézo-électrique (10, 50, 80) selon la revendication 14.
